Europäisches Patentamt

European Patent Office

Office européen des brevets

(11) Publication number : **0 370 114 B1**

# (12) EUROPEAN PATENT SPECIFICATION

(45) Date of publication of patent specification :
**02.08.95 Bulletin 95/31**

(51) Int. Cl.$^6$ : **G06K 19/077**

(21) Application number : **89905205.4**

(22) Date of filing : **19.04.89**

(86) International application number :
**PCT/JP89/00418**

(87) International publication number :
**WO 89/10269 02.11.89 Gazette 89/26**

(54) **IC CARD AND PRODUCTION METHOD THEREOF.**

(30) Priority : **20.04.88 JP 97071/88**
**20.04.88 JP 97076/88**
**21.04.88 JP 98661/88**

(43) Date of publication of application :
**30.05.90 Bulletin 90/22**

(45) Publication of the grant of the patent :
**02.08.95 Bulletin 95/31**

(84) Designated Contracting States :
**CH DE FR GB IT LI NL SE**

(56) References cited :
**FR-A-02 595 848**
**JP-A-57 210 494**
**JP-A-58 135 656**
**JP-A-62 103 195**
**JP-A-62 240 594**

(73) Proprietor : **MATSUSHITA ELECTRIC**
**INDUSTRIAL CO., LTD.**
**1006, Oaza Kadoma**
**Kadoma-shi, Osaka-fu, 571 (JP)**

(72) Inventor : **UENISHI, Mitsuaki**
**47-8, Zushi 3-chome**
**Takatsuki-shi Ozaka-fu 569 (JP)**
Inventor : **TAKASE, Yoshihisa**
**Haimukonoike 508 gou**
**5-17, Konoikecho 2-chome**
**Higashiosaka-shi Osaka-fu 578 (JP)**
Inventor : **FUJII, Takashi**
**13-16, Myokenzaka 5-chome**
**Katano-shi Osaka-fu 576 (JP)**

(74) Representative : **Schwabe - Sandmair - Marx**
**Stuntzstrasse 16**
**D-81677 München (DE)**

EP 0 370 114 B1

## Description

Technical Field

This invention relates to an Ic card according to the preamble of claim 1 and a method for manufacturing IC cards according to the preamble of claim 7 which has an IC module incorporating an IC chip that processes or stores data, can exchange data with external devices, and can be carried and used as a cash card, credit card, identification card or the like.

Background Art

A so-called IC card, which incorporates an IC module containing an IC chip having a microcomputer and memories therein and having a series of connection terminals for exchanging data with external devices buried in a card base, is widely known, and its standardization is in process at the ISO (International Organization for Standardization). In comparison with conventional magnetic stripe cards, since such IC cards have a larger memory capacity and are superior in security, practical usages are considered in many fields such as financial businesses, medical institutes and personal identification. The portability of the IC cards are greatly advantageous like that of conventional magnetic stripe cards. Therefore, to put the IC cards into practical use, the reliability must be securely guaranteed in the environment where the IC cards are used, that is, resistance to bending of IC card and protection of the incorporated IC chip from external stresses. Nowadays, this is an important problem.

As a conventional example, a sectional view of an IC card in JP-A-58-92597 is shown in Figure 8. This IC card is constructed by an IC module **32** incorporating an IC chip and having connection terminals **34** with external devices which are adhered inside of a concave portion **33** formed in a specified position on a card base **31** with an adhesive **35**. An IC card having such a construction is produced by punching out a card base **31** in a desired size, forming a concave portion **33** with a size similar to an IC module **32** in a desired position, disposing the IC module **32** inside of the concave portion **33** of the card base **31** by using the adhesive **35** in such a way that the surface of the connection terminals **34** is flush with the surface of the card base **31**.

However, in such conventional IC cards, when the both ends of the card base **31** are bent upward, the inside surface of the concave portion **33** strongly presses the IC module **32** inward by means of the adhesive **35**, so that the IC chip incorporated in the IC module **32** might be damaged. If the IC chip is protected from the bending stress of IC card by increasing the rigidity of the IC module **32**, even when the IC module **32** is pressed by the inside surface of the concave portion **33**, because the IC module **32** is rigid, it does not change its form, and reversely, the bending stress of the card base **31** is centralized on the boundary portion between the inside surface and the inside bottom surface of the concave portion **33**, thereby damaging the card base **31** at the boundary portion.

An IC card as acknowledged in the preamble of claim 1 is known from JP-A 62-103195 and comprises a card base, an IC module constructed in a first concave portion formed in the card base, wherein a gap is formed between the inside surface of the first concave portion and the outside surface of the IC module, said gap being wider in the inside upper part of the first concave portion and narrower in the inside lower part of the first concave portion.

Furthermore JP-A 58-135656 shows a different form of an IC module having recesses of different formation arranged at different locations in the IC module. This document, however, does not anticipate an IC module having a second concave portion formed in the inside bottom surface of the first concave portion and an adhesive adhering the IC module to the inside bottom surface of the first concave portion.

Lastly FR-A 2 595 848 teaches the elastic flexible mounting of an IC module relative to the main card body.

Disclosure of the Invention

It is a primary object of the invention to present an IC card and a method for the manufacture of IC cards in which the IC chip in the IC module and card base are not damaged even when the IC card is bent.

This object is achieved by the features of the characterizing part of claim 1 for the IC card and by the features of the characterizing part of claim 7 for the method for the manufacture of IC cards.

In such a construction of the IC card, even when both sides of the card base are bent upwardly, owing to the presence of a gap between the inside surface of the first concave and the outside surface of the IC module, the inside surface of the first concave does not press the IC module inwardly. Therefore, the IC chip and the card base itself are not damaged when the card base is bent.

Brief Description of the Drawings

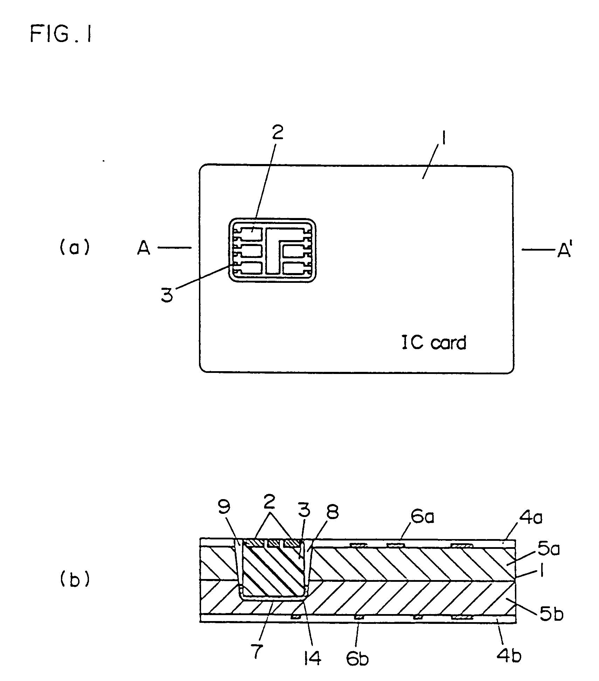

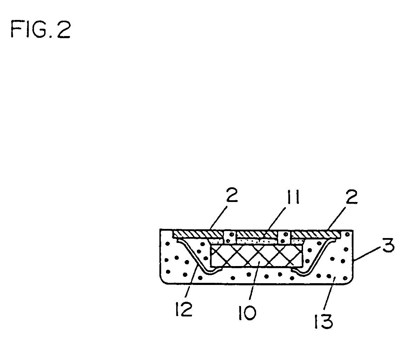

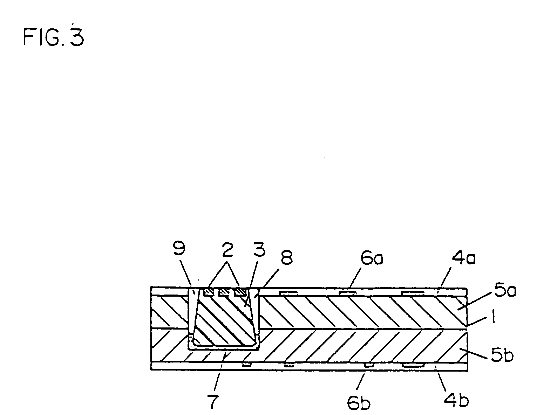

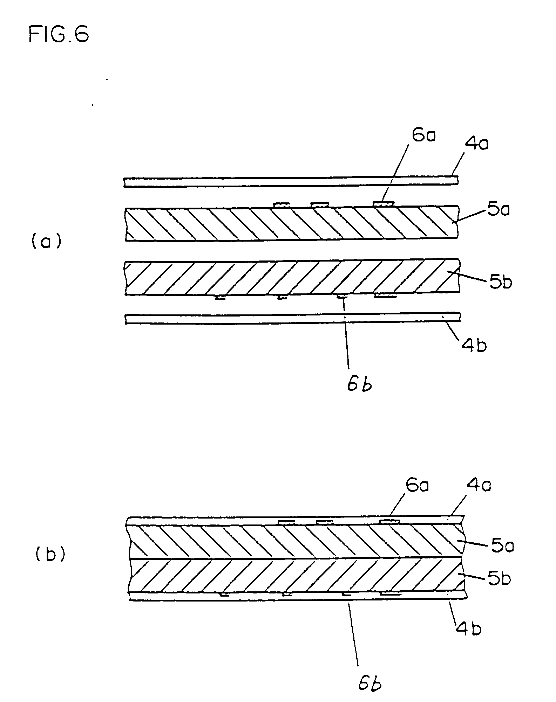

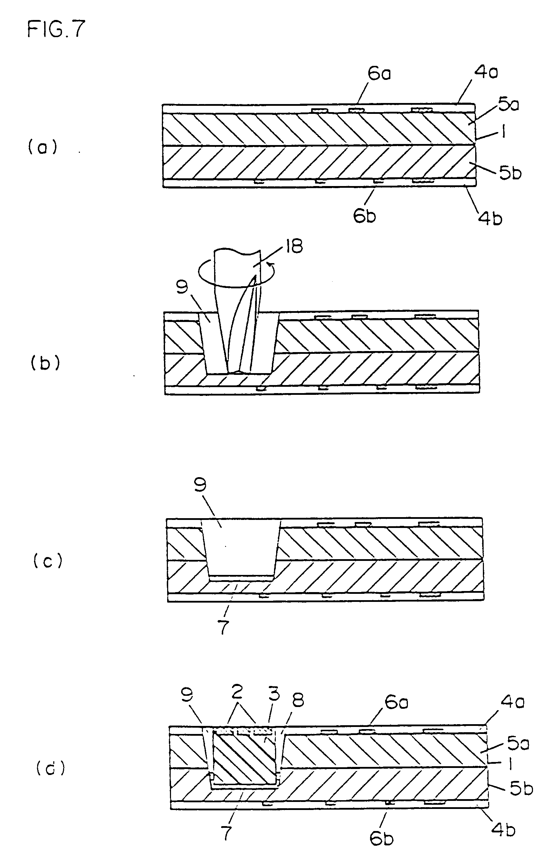

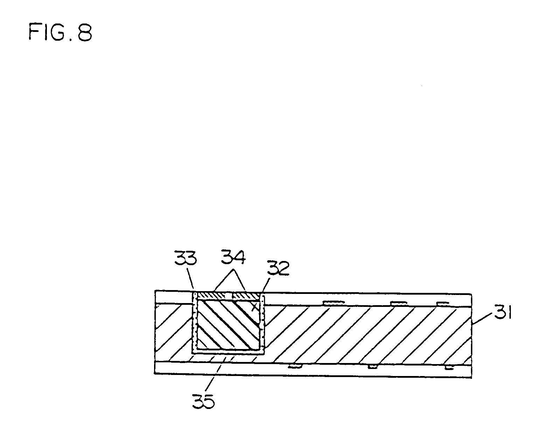

Figures 1a und b are a top view showing an IC card of thisinvention and a sectional view along line A-A' of Figure 1a, Figure 2 is a sectional view showing an IC module used in an IC card of the invention, Figures 3, 4 and 5 are sectional views showing other IC cards of the invention, Figures 6a, b and Figures 7a to d are sectional views showing methods for manufacturing an IC card of the invention, and Figure 8 is a sectional view showing a conventional an IC card.

Best Mode for Carrying out the Invention

Referring to the drawings, one of the embodiments of the invention is described in detail below. Figures 1 and 2 show one embodiment of the invention. As shown in Figure 2, an IC module 3 incorporating an IC chip 10 and having a series of connection terminals 2 to exchange data with external devices is positioned in a first concave portion 9 that is formed in a specified position of a card base 1 shown in Figure 1 in such a manner that the surface of each connection terminal 2 is flush with the surface of the card base 1. The IC module 3 in such a state is adhered to the inside bottom part of the first concave 9 by means of an adhesive 7. The card base 1 is composed of two center cores 5a and 5b made of white colored rigid vinyl chloride resin and two over-sheets 4a and 4b made of transparent vinyl chloride resin that are disposed on the surfaces of the center cores 5a and 5b, respectively. Between the center core 5a and the over-sheet 4a, and between the center core 5b and the oven-sheet 4b, although not shown in Figure 1a, desired letters and patterns 6a and 6b which are visible through the over-sheets 4a and 4b are formed by a printing technique. The thickness of the center cores 5a and 5b are both 0.35 mm, that of over-sheets 4a and 4b are both 0.03 mm, the overall thickness of the card base 1 is 0.76 mm, and the overall dimensions are the same as credit cards. As shown in the sectional view in Figure 2, the IC module 3 used in this IC card comprises a connection terminal 2 composed of a metallic thin plate, one surface of which is exposed outside and on the other surface an IC chip 10 that processes or stores data is mounted with an insulating adhesive 11. The IC chip 10 is connected to the connection terminal 2 by a metallic wire 12, and these members are covered with a sealing resin 13 made of an epoxy resin. By the transfer molding method, the IC chip 10 and the peripheral members (adhesive 11, metallic wire 12, sealing resin 13 and connection terminal 2) are molded into one body. The overall dimensions of this IC module 3 are 10.2 x 12.4 mm, and the thickness is 0.59 mm. The IC chip 10 works by connecting five out of six connection terminals 2, which are exposed on the surface of the IC module 3 as shown in Figure 1a, to an external device.

As shown in Figure 1b, the inside surface of the first concave portion 9 formed in the card base 1 continuously inclines inward toward the inside bottom surface of this first concave portion 9, and between the inside surface of the first concave portion 9 and the outside surface of the IC module 3 adhered to the inside bottom surface of the first concave portion 9, there is formed an inclined gap 8 which is wider at the inner upper part of the first concave portion 9 and narrower at the inner lower part of the first concave portion 9. In an IC card having such a construction, in the case that the both sides of the card base 1 are bent downward, the gap 8 between the inside surface of the first concave portion 9 and the outside surface of the IC module 3 simply opens and the inside surface of the first concave portion 9 does not press the outside surface of the IC module 3 inward, so that a bending stress does not work on the IC module 3. Reversely, in the case that the both sides of the card base 1 are bent upward, the inside surface of the first concave portion 9 changes positions more at the inner upper part of the first concave portion 9 and less at the inner lower part thereof, centering around the boundary portion 14 of the said inside surface and the said inside bottom surface, and comes very close to the outside surface of the IC module 3. Since the inclined gap 8 which is wider at the inner upper part of the first concave portion 9 and narrower at the inner lower part is formed between the inside surface of the first concave portion 9 and the outside surface of the IC module 3, so long as the card base 1 is exceedingly bent, the inside surface of the first concave portion 9 and the outside surface of the IC module 3 do not directly contact. Therefore, a bending stress of the card base 1 does not work on the IC module 3. In a portion of the card base 1 that is close to the boundary portion 14 of the inside surface and the inside bottom surface of the first concave portion 9, a tension or a bending stress which may be created in the case that the inside surface of the inner upper part of the first concave portion 9 and the outside surface of the IC module 3 contact each other is not generated. Thus, even if both sides of the card base 1 are bent either upward or downward, the IC module 3 and the card base 1 are protected from the bending stress.

As a result of our various experiments, it is proved that by forming the inside surface of the first concave portion 9 at an inclination of 10 deg., against the perpendicular and setting the internal angle between the inside surface of the first concave portion 9 and the outside surface of the IC module 3 at 10 deg., the IC module 3 and the card base 1 are protected at a practical level against a bending of the IC card. The inner dimensions of the inside bottom surface of the first concave portion 9 are set at 10.28 x 12.48 mm, taking the allowance of the inner dimensions and the allowance of the outer dimensions of the IC module **3** in consideration, and the depth of the first concave portion **9** is set so that the thickness of the remaining part of the card base **1** at the lower inside bottom surface of the first concave portion **9** becomes 0.15 mm. The thickness of the remaining part of the card base **1**, 0.15 mm, is composed of a thickness 0.03 mm of the over-sheet **4b** and the remaining thickness 0.12 mm of the center core **5b**, and this composition is an important factor that determines durability and strength of the card base **1** against bending, as the thickness of the card base **1** is the smallest.

Then, as comparison examples, IC cards were produced by setting the remaining thickness 0.15 mm of the card base **1** to be constant and changing the thickness of the over-sheet **4b** from 0.03 mm of the embodiment to 0.05 mm and 0.08 mm. The results of examining the durability of the IC cards against bending are shown in Table 1 below. The bending test was performed by bending the shorter edges of the IC cards downward with an amplitude of 10 mm at a speed of 30 times per minute, and the number of times of bending until a crack occurred in the card base **1** at the lower inside bottom surface of the first concave portion **9** were evaluated.

Table 1

| Thickness of over-sheet<br><br>Evaluation items | 0.03 mm | 0.05 mm | 0.08 mm |
|---|---|---|---|
| Average value | 1310 | 799 | 622 |
| Standard deviation | 244 | 91 | 171 |

As shown in Table 1, an IC card of the embodiment with the over-sheet **4b** of 0.03 mm in thickness has the largest bending durability. In addition, the transparent over-sheets **4a** and **4b** of 0.03 mm are useful in that the letters and patterns **6a** and **6b** are clearly visible therethrough. The use of the over-sheets **4a** and **4b** with a thickness of less than 0.03 mm is not desired because they do not protect the letters and patterns **6a** and **6b** and they are inferior in handling. As the adhesive **7** that adheres the bottom surface of the IC module **3** to the inside bottom surface of the first concave portion **9**, a silicone resin adhesive, the main ingredient of which is a denaturated polymer of silicone having a rubbery elasticity even after it is hardened, was used. As the denaturated polymer of silicone, for example, a silicone resin denaturated by the addition of an epoxy resin with elasticity was used, the epoxy resin being obtained by the addition of an amine adduct of polypropylene glycol glycidyl ether to a bisphenol epoxy resin. As comparison examples, IC cards were produced by using, instead of the adhesive **7** with a rubbery elasticity, an epoxy resin adhesive containing denaturated polyamine hardener and an acrylic resin adhesive as adhesives having some flexibility but not rubbery elasticity after hardening, and the mechanical characteristics (bending characteristics, twisting characteristics, shock-resistance) of the IC cards were evaluated. The evaluation results are shown in Table 2. In Table 3, the results of environmental experiment of IC cards of this embodiment are shown. The IC cards of the embodiment have no problem with mechanical strength, chemical resistance, humidity resistance and water resistance, and have a sufficient reliability.

Table 2

| | Embodiment | Comparative example | Comparative example |
|---|---|---|---|
| Adhesive | Silicone resin with a denaturated polymer of silicone as its main ingredient | Epoxy resin | Acrylic resin |
| Bending character- istics *1) | 2300 times or more | 250 times or more | 300 times or more |
| Twisting character- istics *2) | OK | NG | NG |
| Shock- resistance | ◯ | ✕ | ✕ |

*1) Bending characteristics;
   experimented by bending the cards in the shorter direction and the longer direction on both faces of the cards, top and bottom, and right and left.
Longer direction; flexibility (f): 20 mm,
   periodicity; bending for 30 times/min
Shorter direction; flexibility (f): 10 mm,
   periodicity; bending for 30 times/min

Neither the function of a card is lost after the bending test nor remarkable cracks arise.

*2) Twisting characteristics;
   When the IC card is twisted with ±15 deg., 30 times/min and 1,000 times, around the axis in the longitudinal direction, the IC module is not peeled off, remarkable cracks do not arise and IC performance is still normal.

Table 3

| Item | Sodium carbonate 1% 24Hr | Brine 5% 24Hr | Acetic acid 5% 24Hr | Alcohol 100% 24Hr | Hot water 60°C 1Hr | Humidity resistance 40°C 90% 74Hr | Heat-shock -40°C to 50°C 24c/s | Dropping concrete 1.5 m |
|---|---|---|---|---|---|---|---|---|
| Embodi-ment | ◯ | ◯ | ◯ | ◯ | ◯ | ◯ | ◯ | ◯ |

In the IC card of the embodiment, since the adhesive 7 has a rubbery elasticity even after hardening, outside stress and shock are weakened by this adhesive 7, and thus, even when bending, twists and shocks are applied to the card base 1, the IC module 3 was not peeled off from the first concave portion 9, neither cracks occurred in the card base 1 nor abnormal operating performance of the IC chip 10 was caused. In the IC card of the embodiment, it is considered that a small amount of the adhesive 7 between the bottom surface of the IC module 3 and the inside bottom surface of the first concave portion 9 invades into the gap 8 between the outside surface of the IC module 3 and the inside surface of the first concave portion 9, but as shown in Table 2, the phenomenon has no effect on the mechanical characteristics of the IC card.

Figures 3 to 5 show sectional views of other embodiments of the invention. In the embodiment of Figure 3, the outside surface of the IC module 3 is inclined outward toward a lower portion, so that an inclined gap 8 which is wider at the inside upper part of the first concave portion 9 and narrower at the inside lower part is formed between the inside surface of the first concave portion 9 and the outside surface of the IC module 3. The bottom surface of the IC module 3 is adhered to the inside bottom surface of the first concave portion 9 by means of an adhesive having a rubbery elasticity even after hardening. It is evident from the embodiment of Figure 1 that the IC module 3 and the card base 1 of the inside bottom surface of the first concave portion 9 are protected from bending stresses even when the card base 1 is bent upward or downward. Of course, when the outside surface of the IC module 3 is made wide outward toward a lower portion thereof and the inside surface of the first concave portion 9 is inclined inward toward the bottom surface of the first concave portion 9, a linearly inclined gap 8 which is wider at the inside upper part of the first concave portion 9 and narrower at the inside lower part is formed between the inside surface of the first concave portion 9 and the outside surface of the IC module 3, and thus, the reliability of the IC card against bending stress is further improved.

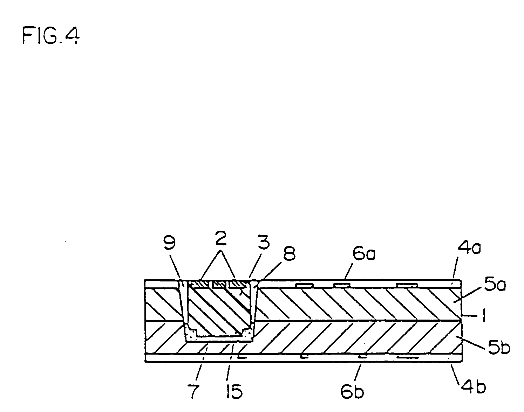

In the embodiment of Figure 4, an inclination is constructed inward in the direction of the inside bottom surface of the first concave portion on the inside surface of the first concave portion 9, and an inclined gap 8 which is wider at the inside upper part and narrower at the inside lower part of the first concave portion 9 is formed between the inside surface of the first concave portion 9 and the outside surface of the IC module 3. A convex portion 15 is formed in the middle of the bottom surface of the IC module 3, and the bottom surface of the IC module 3 and the inside bottom surface of the first concave portion 9 are adhered by means of an adhesive 7 having a rubbery elasticity even after hardening. The thickness of the adhesive 7 on the bottom surface of the IC module 3 is larger at the peripheral part than the center part where the convex portion 15 is formed. It is effective to increase the thickness of the adhesive 7 in order to prevent the IC module 3 from peeling off from the first concave portion 9 in the case that both sides of the base 1 are bent downward. The adherence itself increases as well as its expandability with an increase in the thickness of the adhesive 7, so that the IC module 3 can be stably held inside of the first concave portion 9. It is more important to increase the thickness of the adhesive 7 at the peripheral part than at the center part of the bottom surface of the IC module 3 in order that the IC module 3 is stably held inside of the concave portion without peeling off in the initial stage. In the embodiment of Figure 4, the height of the convex portion 15 on the bottom surface of the IC module 3 is set at 0.02 mm, and the thickness of the adhesive 7 is formed to be 0.02 mm in the center part of the bottom surface of the IC module **3** and 0.04 mm in the peripheral part. In order to increase the thickness of the adhesive **7**, it is required to decrease the thickness of the IC module **3** or the thickness of the remaining portion of the card base **1** that faces the inside bottom surface of the first concave portion **9**, but it deteriorates the mechanical strength of the IC module **3** or the card base **1**. However, in the IC card shown in the embodiment of Figure 4, it is possible to increase the thickness of the adhesive **7** without decreasing the thickness of the center part of the IC module **3** in which the IC chip is incorporated, and it enables to improve the initial exfoliation strength between the IC module **3** and the card base **1** without deteriorating the rigidity of the IC module **3**. Moreover, even if the thickness of the adhesive **7** between the convex portion **15** on the bottom surface of the IC module **3** and the inside bottom surface of the first concave portion **9** is reduced, the thickness of the adhesive **7** between the peripheral part of the bottom surface of the IC module **3** and the inside bottom surface of the first concave portion **9** can be obtained so that the IC module **3** is stably held inside of the first concave portion **9** which creates no problem.

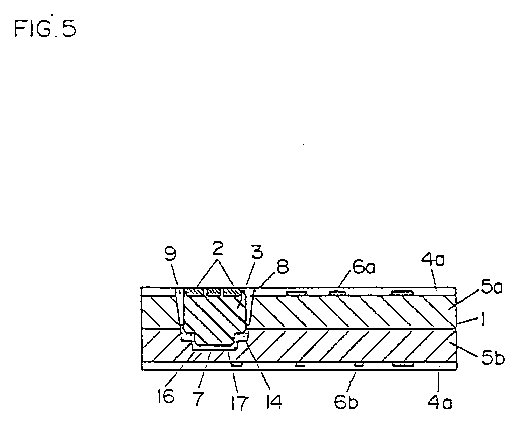

In the embodiment of Figure 5, a first concave portion **9** is formed at a specified position in the card base **1**, and a second concave portion **16** is formed in the inside bottom surface of the first concave portion **9**. The inside surfaces of both the first concave portion **9** and the second concave portion **16** are inclined inward toward the inside bottom surfaces of the first concave portion **9** and the second concave portion **16**, respectively. Therefore, between the inside surfaces of the first concave portion **9** and the outside surface of the IC module **3** and between the second concave **16** and the convex portion **17** of the IC module that is positioned in the second concave portion **16**, an inclined gap **8** which is wider in the inside upper part and narrower in the inside lower part of each of the first concave portion **9** and the second concave portion **16** is formed. In the center part of the bottom surface of the IC module **3**, a convex portion **17** that is positioned in the second concave portion **16** is formed, and the bottom surface of the IC module **3** is adhered to the inside bottom surfaces of the first concave portion **9** and the second concave portion **16** by means of an adhesive **7** having a rubbery elasticity even after hardening. The height of the convex portion **17** on the bottom surface of the IC module **3** is 0.1 mm, the thickness of the remaining portion of the card base **1** that faces the lower inside bottom surface of the first concave portion **9** is 0.25 mm, the thickness of the remaining portion of the card base **1** that faces the lower inside bottom surface of the second concave portion **16** is 0.15 mm, the thickness of the adhesive **7** between the inside bottom surface of the first concave portion **9** and the bottom surface of the IC module **3** is 0.02 mm, and the thickness of the adhesive **7** between the inside bottom surface of the second concave portion **16** and the convex portion **17** is 0.02 mm. In this construction, since the card base **1** is bent around the boundary portion **14** between the inside surface of the first concave portion **9** and the inside bottom surface of the first concave portion **9**, even in the case that the inside surface of the first concave portion **9** is not brought into contact with the outside surface of the IC module **3**, a bending stress is generated on a portion of the card base **1** in the vicinity of the boundary portion **14**. However, in the IC card of the embodiment of Figure 5, because the thickness of the remaining portion of the card base **1** in the vicinity of the boundary portion **14** can be made larger than that of the embodiment of Figure 3 and the area of the inside bottom surface of the second concave portion **16** can be decreased as much as possible where the thickness of the card base is the smallest, the mechanical strength and the durability of the card base **1** against the bending stress can be improved. This effect is especially effective when the both sides of the IC card are bent downward. With an IC card having both IC module **3** and magnetic stripes, data in the magnetic stripes can be read by inserting the IC card into a reading device such as ATM. Rollers for conveying a cash card of an existing ATM drive in the center part of the cash card, and in the IC card approved by ISO, the rollers driving the IC card run over the IC module **3**. Therefore, a large load is generated especially in the peripheral part of the IC module **3**, and the card base **1** of the bottom part of the IC module **3** migh t be damaged. However, when an IC card such as that of the embodiment of Figure 5 is formed, the thickness of the card base **1** can be made larger in the peripheral part of the bottom surface of the IC module **3** and it withstands the load of the rollers for driving IC cards. That is, the IC card is superior in durability.

Moreover, since the convex portion **17** in the center part of the IC module **3** occupies a major part of the bottom surface of the IC module **3**, even though the thickness of the peripheral part of the IC module **3** is reduced to some extent, the rigidity of the IC module **3** does not deteriorate and the IC chip incorporated in the IC module **3** is not damaged by the above-mentioned load.

The foregoing embodiments disclose the IC cards having an inclined gap **8** between the inside surface of the first concave portion **9** and the outside surface of the IC module **3**, wherein the distance between the inside surface of the first concave portion **9** and the outside surface of the IC module **3** linearly narrows from the inside upper part toward the inside lower part of the first concave portion **9**.

As far as a gap **8** which is wider in the outside upper part and narrower in the inside lower part of the first concave portion **9** exists between the inside surface of the first concave portion **9** and the outside surface of the IC module **3**, in the middle part positioned between the inside upper part of the first concave portion **9** and the inside lower part of the first concave portion **9**, the gap **8** between the inside surface of the first concave portion **9** and the outside surface of the IC module **3** can be formed in any shape such as a curve or steps.

Next, a manufacturing method of IC cards of the invention is described by mainly explaining the IC card of the embodiment in Figure 1, referring to sectional views of the IC card shown in Figures 6 and 7.

As a large sheet card material from which plural IC cards can be obtained, over-sheets **4a** and **4b** of 0.03 mm in thickness made of a transparent vinyl chloride resin and center cores **5a** and **5b** of 0.35 mm in thickness made of a white opaque rigid vinyl chloride resin are prepared. On the surfaces of the center cores **5a** and **5b**, logos, design letters and patterns **6a** and **6b** necessary for an IC card are formed with a thickness of 0.02 mm or less by a screen printing or offset printing technique (Figure 6a). Next, the over-sheet **4b** and the over-sheet **4a** are placed on the top and in the bottom, respectively, and between these over-sheets **4a** and **4b**, the center cores **5a** and **5b** are stacked so that the letters and patterns **6a** and **6b** face to the over-sheets **4a** and **4b**, respectively, after which they are put between mirror-finished stainless steel plates, and heated to 100°C-150°C and cooled while applying a pressure of 15 to 35 Kg/cm$^2$ for several tens of minutes to obtain a large laminate of 0.76 mm in thickness (Figure 6b). By cutting this laminate to separate it into individual IC cards and removing those having damage in the letters and patterns **6a** and **6b** or cards themselves, a card base **1** used for an IC card of the invention can be obtained (Figure 7a). A protective layer of the over-sheets **4a** and **4b** of 0.01 mm or more in thickness is formed over the letters and patterns **6a** and **6b**, and a gap between the letters and patterns **6a** and **6b** and the center cores **5a** and **5b** are buried by the over-sheets **4a** and **4b**, thus the surface of the card base **1** is finished flat. Next, by using a numerically controlling drilling device equipped with a drill **18**, a cutting treatment is executed to form the first concave portion **9** in a specified position of the card base **1** into which the IC module **3** is inserted (Figure 7b). In the leading part and the peripheral part of the drill **18**, a linear cemented carbide tip is disposed, and in the peripheral part, an inclination is formed so that the diameter of the drill **18** becomes smaller from the upper part to the leading part of the drill **18**, which has an inclination of 10 deg., against the perpendicular. By driving the drill **18** at a high speed, lowering it to a specified depth from the surface of the card base **1**, and then, relatively moving the drill **18** and the card base **1** in a horizontal direction in accordance with the shape of the first concave portion **9**, the first concave portion **9** is formed. On the inside surface of the first concave portion **9**, the inclination of the drill **18** is transcribed and an inclination of 10 deg. is formed inward toward the inside bottom surface of the first concave portion **9**. In the case that the second concave portion **16** in the card base **1**, such as that of the IC card of the embodiment of Figure 5 is formed, the drill **18** is lowered again to a specified depth and the drill **18** and the card base **1** are relatively moved in a horizontal direction in accordance with the shape of the second concave portion **16**. The outer dimensions of the inside bottom surface of the first concave portion **9** is 10.28 x 12.48 mm, the depth of the first concave portion **9** is 0.61 mm and the thickness of the remaining portion of the card base **1** that faces the first concave portion **9** is 0.15 mm. Thereafter, by using a dispenser, a few milligrams of the adhesive **7** that has a denaturated polymer of silicone as its main ingredient and that has a rubbery elasticity even after hardening is dropped on the inside bottom surface of the first concave portion **9** (Figure 7c). The IC module **3** is molded by the transferring molding method with an outer size of 10.2 x 12.4 mm and a thickness of 0.59 mm, connection terminals **2**, an IC chip **10** and metallic wires **11** being incorporated into the IC module in one body as shown in Figure 2. In IC cards of the embodiments of Figures 4 and 5, the convexes portion **15** and **17** of the bottom surface of the IC module **3** are formed by conforming the inner shape of a mold used for the transferring molding method to the shapes of the convexes portion **15** and **17**.

Then, the IC module **3** is inserted into the first concave portion **9** so that the connection terminal **2** exposes in the surface of the card base **1**, and by using a pressing device, the surface of the IC module **3** is pressed for 30 to 40 sec., under a pressure of 3.8 to 6.2 g/mm$^2$.

The IC module **3** is smoothly inserted into the first concave portion **9** along the inclination constructed in the inside surface of the first concave portion **9**, and in the inside lower part of the first concave portion **9**, the gap **8** between the inside surface of the first concave portion **9** and the outside surface of the IC module **3** is narrow, so that the IC module **3** hardly moves inside of the first concave portion **9**. Therefore, by simply dropping the IC module **3** into the first concave portion **9**, the IC module **3** is precisely positioned in a specified position of the card base **1** without using special device. Then the pressing is discontinued, the IC card is inserted in a magazine and heated for 40 to 70 mins., at a temperature of 45 to 55°C to primarily harden the adhesive **7**, and then successively leaving the card for 48 hours at room temperature, the adhesive **7** is secondarily hardened.

The thickness of the adhesive **7** is formed in 0.02 mm after it is completely hardened, and the thickness of the IC card becomes 0.76 mm.

In such a way, an IC card of the invention, in which a linearly inclined gap **8** which is wider in the inside upper part and narrower in the inside lower part of the first concave portion **9** is formed between the inside surface of the first concave portion **9** and the outside surface of the IC module **3**, is obtained (Figure 7d). By this manufacturing method, the adhesive **7** is hardened at a temperature lower than the thermal deformation temperature of the card base **1** and only a very small pressure is applied to the IC module **3**, so that any change in shape of the card base **1** or damage in the IC module **3** does not occur.

Industrial Applicability

As mentioned above, according to this invention, a gap which is wider in the inside upper part and narrower in the inside lower part of the first concave portion is formed between the inside surface of the first concave portion formed in the card base and the outside surface of the IC module constructed in the first concave portion, and even when the card base is bent, the inside surface of the first concave portion does not strongly press the outside surface of the IC module inward.

Therefore, the IC chip in the IC module and the card base itself are hardly damaged.

## Claims

1. An IC card comprising a card base (1), an IC module (3) constructed in a first concave portion (9) formed in the card base (1), wherein a gap (8) is formed between the inside surface of the first concave portion (9) and the outside surface of the IC module (3), said gap being wider in the inside upper part of the first concave portion (9) and narrower in the inside lower part of the first concave portion (9), characterized in that an adhesive (7) adheres the IC module (3) to the inside bottom surface of the first concave portion (9), a second concave portion (16) is formed in the inside bottom surface of the first concave portion (9), and a convex portion (17) for inserting into the second concave portion (16) is formed on the bottom surface of the IC module (3).

2. An IC card according to claim 1, wherein the outside surface of the IC module (3) is inclined outward toward a lower part thereof.

3. An IC card according to claim 1, characterized in that the difference between the inside surface of the first concave portion (9) and the outside surface of the IC module gradualle becomes narrower from the inside upper part of the first concave portion (9) toward the inside lower part of the first concave portion (9).

4. An IC card according to claim 1, characterized in that the inside surface of the first concave portion (9) is inclined inwardly toward the inside bottom surface of the first concave portion (9).

5. An IC card according to claim 1 and to claim 3, wherein the adhesive is elastic.

6. An IC card according to claim 5, wherein an adhesive ccontaining a denaturated polymer of silicone as a main ingredient is used as an adhesive.

7. A method for the manufacture of IC cards comprising the steps of forming a first concave portion (9) with the inside surface inclined inwardly toward a lower part thereof in a specified portion of card base (1), placing an IC module (3) in the first concave portion (9), and pressing this IC module (3) against the inside bottom surface of the first concave portion (9), characterized by the following features:
   forming a second concave portion (16) in the inside bottom surface of the first concave portion (9), applying an adhesive (7) on a inside bottom surface of the first concave portion (9), inserting a convex portion (17) that is formed on the bottom surface of the IC module (3) into the second concave portion (16), and hardening the adhesive (7).

## Patentansprüche

1. IC-Karte mit einer Kartenbasis (1), einem IC-Modul (3), das in einem ersten, in der Kartenbasis (1) ausgebildeten konkaven Abschnitt (9) ausgestaltet ist, bei der ein Spalt (8) zwischen der inneren Oberfläche des ersten konkaven Abschnittes (9) und der äußeren Oberfläche des IC-Moduls (3) ausgebildet ist, wobei der Spalt am inneren oberen Teil des ersten konkaven Abschnittes (9) breiter und am inneren unteren Teil des ersten konkaven Abschnittes (9) schmaler ist, **dadurch gekennzeichnet,** daß ein Klebstoff (7) das IC-Modul (3) an die innere Bodenoberfläche des ersten konkaven Abschnittes (9) anklebt, ein zweiter konkaver Abschnitt (16) in der inneren Bodenoberfläche des ersten konkaven Abschnittes (9) ausgebildet ist, und ein konvexer Abschnitt (17) zum Einsetzen in den zweiten konkaven Abschnitt (16) auf der Bodenoberfläche des IC-Moduls (3) ausgebildet ist.

2. IC-Karte nach Anspruch 1, bei der die äußere Oberfläche des IC-Moduls (3) in Richtung seines unteren Teils nach außen geneigt ist.

3. IC-Karte nach Anspruch 1, dadurch gekennzeichnet, daß der Abstand zwischen der inneren Oberfläche des ersten konkaven Abschnittes (9) und der äußeren Oberfläche des IC-Moduls allmählich von dem inneren oberen Teil des ersten konkaven Abschnittes (9) zum inneren unteren Teil des ersten konkaven Abschnittes (9) hin schmaler wird.

4. IC-Karte nach Anspruch 1, dadurch gekennzeichnet, daß die innere Oberfläche des ersten konkaven Abschnittes (9) nach innen in Richtung auf die innere Bodenoberfläche des ersten konkaven Abschnittes (9) geneigt ist.

5. IC-Karte nach Anspruch 1 und Anspruch 3, bei der der Klebstoff elastisch ist.

6. IC-Karte nach Anspruch 5, bei der ein Klebstoff, der als Hauptbestandteil ein denaturalisiertes Polymer des Silikons enthält, als Klebstoff verwendet wird.

7. Verfahren zur Herstellung von IC-Karten mit den Schritten: Ausbilden eines ersten konkaven Abschnittes (9), dessen innere Oberfläche nach innen in Richtung seines unteren Teils geneigt ist, in einem bestimmten Abschnitt der Kartenbasis (1), Plazieren eines IC-Moduls (3) in dem ersten konkaven Abschnitt (9) und Pressen dieses IC-Moduls (3) gegen die innere Bodenoberfläche des ersten konkaven Abschnittes (9), **gekennzeichnet durch** die folgenden Merkmale:
Ausbildung eines zweiten konkaven Abschnitts (16) in der inneren Bodenoberfläche des ersten konkaven Abschnitts (9), Aufbringen eines Klebstoffes (7) auf eine innere Bodenoberfläche des ersten konkaven Abschnittes (9), Einsetzen eines konvexen Abschnittes (17), der an der Bodenoberfläche des IC-Moduls (3) ausgebildet ist, in den zweiten konkaven Abschnitt (16) und Aushärten des Klebstoffes (7).

**Revendications**

1. Carte pour circuits intégrés (CI) comprenant une base (1) de carte, un module CI (3) construit dans une première portion concave (9) formée dans la base (1) de la carte, où un interstice (8) est formé entre la surface intérieure de la première portion concave (9) et la surface extérieure du module CI (3), ledit interstice étant plus large dans la partie intérieure supérieure de la première portion concave (9) et plus étroit dans la partie intérieure inférieure de la première portion concave (9), caractérisée en ce qu'un adhésif (7) fait adhérer le module CI (3) à la surface intérieure inférieure de la première portion concave (9), une seconde portion concave (16) est formée dans la surface intérieure inférieure de la première portion concave (9), et une portion convexe (17) pour insertion dans la seconde portion concave (16) est formée sur la surface inférieure du module CI (3).

2. Carte CI selon la revendication 1, dans laquelle la surface extérieure du module CI (3) est inclinée vers l'extérieur dans la direction d'une partie inférieure de celui-ci.

3. Carte CI selon la revendication 1, caractérisée en ce que la différence entre la surface intérieure de la première portion concave (9) et la surface extérieure du module CI devient progressivement plus étroite à partir de la partie intérieure supérieure de la première portion concave (9) vers la partie intérieure inférieure de la première portion concave (9).

4. Carte CI selon la revendication 1, caractérisée en ce que la surface intérieure de la première portion concave (9) est inclinée vers l'intérieur dans la direction de la surface intérieure inférieure de la première portion concave (9).

5. Carte CI selon la revendication 1 et la revendication 3, dans laquelle l'adhésif est élastique.

**6.** Carte CI selon la revendication 5, dans laquelle un adhésif contenant un polymère dénaturé de silicone comme ingrédient principal est utilisé comme adhésif.

**7.** Procédé pour la fabrication de cartes CI comprenant les étapes consistant à former une première portion concave (9) avec la surface intérieure inclinée vers l'intérieur dans la direction d'une partie inférieure de celle-ci dans une portion spécifiée de la base (1) de la carte, à placer un module CI (3) dans la première portion concave (9), et à comprimer ce module CI (3) contre la surface intérieure inférieure de la première portion concave (9), caractérisé par les particularités suivantes :

former une seconde portion concave (16) dans la surface intérieure inférieure de la première portion concave (9), appliquer un adhésif (7) à la surface intérieure inférieure de la première portion concave (9), insérer une portion convexe (17) qui est formée sur la surface inférieure du module CI (3) dans la seconde portion concave (16), et durcir l'adhésif (7).

FIG. I

(a)

2

I

A —

— A'

3

IC card

(b)

9   2   3   8        6a        4a

5a

I

5b

7    I4   6b        4b

FIG.2

FIG. 3

FIG.4

FIG.5

FIG.6

(a)

6a  4a

5a

5b

4b

6b

(b)

6a  4a

5a

5b

4b

6b

FIG.7

(a)

(b)

(c)

(d)

FIG.8